# EUROPEAN PATENT APPLICATION

(11) **EP 1 524 888 A2**
(43) Date of publication of application: **20.04.2005**
(21) Application number: 04005162.5
(22) Date of filing: 04.03.2004
(51) Int. Cl.: H05K 7/00

(54) **Cooling device and electronic apparatus building in the same**

(30) Priority: 17.10.2003 JP 2003357245
(71) Applicant: Hitachi, Ltd., Chiyoda-ku, Tokyo 101-8010 (JP)
(72) Inventor: Suzuki, Osamu, Chiyoda-ku Tokyo 100-8220 (JP); Ohashi, Shigeo, Chiyoda-ku Tokyo 100-8220 (JP); Matsushima, Hitoshi, Chiyoda-ku Tokyo 100-8220 (JP); Matsushita, Shinji, Chiyoda-ku Tokyo 100-8220 (JP); Asano, Ichirou, Chiyoda-ku Tokyo 100-8220 (JP); Minamitani, Rintaro, Chiyoda-ku Tokyo 100-8220 (JP)
(74) Representative: Beetz & Partner Patentanwälte

(57) **Abstract**

In a liquid cooling system (107, 108) of low costs and being installable with high density into a server having a several kinds of predetermined heights of housings, each of devices building up the liquid cooling system is set to be within about 44 mm, being the standard height of a lack when installing into a cabinet for the server lack of lack-mount method, in particular, about from 40 mm to 36 mm, and this is combined with, thereby building up a liquid cooling system of low costs and enabling high density installation, for an electronic apparatus of lack-mount method having different heights.

## Description

### BACKGROUND OF THE INVENTION

The present invention relates to an electronic apparatus, including an electronic computer therein, and in particular, to a liquid cooling device, being applicable into cooling of an information processing apparatus, such as, a server of lack-mount type, thereby enabling to obtain high-performances and small-sizing for such the apparatus.

In the system configuration, space for storage and installation of an information processing apparatus, such as a server, etc., so-called a lack-mount method or type comes to be a main current in recent years. This lack-mount method is a method of installing a housing, being so-called a "lack", for storing the apparatus therein, by stacking, while being divided, into the function units, separately in a unit chassis, being so-called a "cabinet", which is formed or manufactured in accordance with a specific regulation or standard thereof. With such the lack-mount method, there can be obtained advantages that hardware development can be made on the basis of an each unit of the apparatus, and at the same time that selection/disposition of each of the apparatuses can be made freely, thereby being superior in flexibility/extensibility of the system configuration, and further also an area can be reduced, being occupied by the entire system thereof.

In particular, in relation to the server of such the lack-mount method as was mentioned above, a cabinet of nineteen (19) inches width, which is regulated in accordance with the standard of IEC (i.e., International Electrical Commission)/EIA (The Electrical Industries Association), is mainly used, and wherein a frontage between supports on both sides, for installing the apparatus therethough, is 451mm, and a height for the installation is restricted by a unit of 1U (1EIA)=44.45mm. For this reason, the housings of the server of such the lack-mount method, and/or a network apparatus, a disk array apparatus, or an uninterruptible power supply, which are combined therewith, must be constructed within the width thereof, but not regulated, so that it can be installed into the cabinet of the nineteen (19) inches width. Also, with the height thereof, the housings are constructed at a height, such as, 3U (three-times high of the 1U) or 5U ( five-times high of the 1U), for example, so that the housings can be installed within the cabinet, stacking closely to each other.

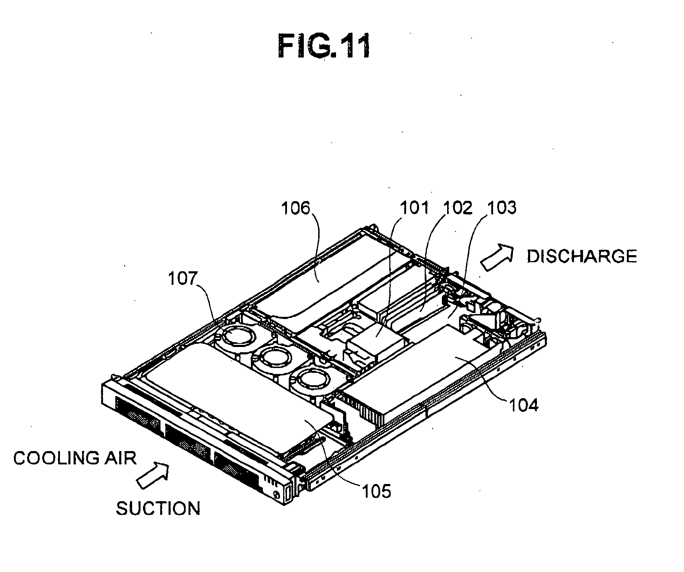

An example of installation of the housings of a server of the lack-mount method is shown in Fig. 11. The housing shown in Fig. 11 has the height of 1U (about 45mm), and it is built up with amain board 103 mounting a CPU (101) and a memory 102, etc. , thereon, an electric power unit 104 building a cooling fan for exclusive use thereof therein, a storage 105 including a HDD and a CD-ROM, or the like therein, and an expansion board 16. Further, a cooling fan 107 is disposed at the central portion of the housing, provided for cooling down the CPU, mainly, thereby achieving the cooling thereof through blowing a cooling air upon a heat sink of the CPU.

With such the housing of the lack-mount type server of the conventional art shown in Fig. 11 mentioned above, an air is sucked into from a front surface of the housing, and the cooking air is discharged from a rear surface of the housing into the periphery thereof. In this instance, due to the flow of this cooling air generated by the cooling fan 107, cooling is also performed upon the electronic parts (not shown in the figure) other than the storage and the CPU disposed in a front portion of the module, such as, a memory 102, etc. As such the cooling technology for the lack-mount method, the structure is disclosed, for example, in the following patent document 1, in which an vent hole is opened at a position near to the front surface on an upper surface of the housing, and an other housing is disposed above, so that this vent hole is not covered therewith when being installing into the cabinet with this.

Also, as a means for obtaining the cooling of an electronic equipment of the lack-mount method, a cooling method is disclosed, for example, in the following patent document 2, in which a cooling system is provided within the cabinet, as well as, flow passages for a coolant provided within a plural number of pillars, thereby building up the cabinet, wherein the coolant is supplied from at least one (1) of the pillars into the housing, so as to absorb the heat generated within the housing therein, and thereafter the coolant absorbing the heat therein is discharged from, i.e., into one of the remaining pillars, thereby obtaining the achieving the cooling thereof.

Also, in the following patent document 3, the heat of a heat-generation parts are received by means of a heat-receiving member, in a cooling method for an electronic equipment, storing a plural number of electronic parts within the housing thereof; wherein a cooling liquid flows in flow passages provided within the heat-receiving member, so as to cool down the heat-receiving member, and the cooling liquid flowing through the heat-receiving member runs into a flow passage of a heat radiation member, which is thermally connected with the hous ing of the electronic apparatus mentioned above, thereby conducting the cooling thereof.

Also, the following patent document 4 describes a small-s ized electronic computer, in which a liquid cooling system is built up therein.

Patent Document 1: Japanese Patent Laying-Open No. 2002-366258 (2002);

Patent Document 2: Japanese Patent Laying-Open No. 2002-374086 (2002);

Patent Document 3: Japanese Patent Laying-Open No. 2003-60372 (2003); and

Patent Document 4: Japanese Patent Laying-Open No. 2003-233441 (2003).

As was disclosed in the patent document 1, high-performances and high-density for installation of an electronic apparatus advances in recent years, and then accompanying with this, it is difficult to achieve the cooling upon the parts thereof, which are installed within the housing, in particular, the cooling of a CPU. As one of the methods, for overcoming such the problem, as was already disclosed in the patent document 2, it can be considered to introduce a liquid cooling device, building up a system, which is closes at least within one unit of the cabinets.

As is shown in Fig. 11 mentioned above, the cooling system applied into the information processing apparatus of the conventional art, such as, the server, etc., it is built up with two (2) parts; such as, a heat sink to be attached onto the heat-generation parts directly, and a cooling fan for blowing a cooling air onto this heat sink. On the contrary to this, the liquid cooling device (or a system) necessitates a pump for circulating the cooling liquid in addition to the cooling fan, and a liquid cooling jacket for use of heat-absorption, in the place of the heat sink, and a radiator for heat radiation, and further conduits for the cooling liquid, so as to connect each of the devices therethrough. Furthermore, there is a necessity of providing a preserver tank, etc., but depending upon the using condition thereof, therefore a number of the pats comes up, greatly. For this reason, cost reduction is a big problem to be dissolved, for the liquid cooling system to be applied as the cooling system, widely, in the electronic apparatus.

Also, with the system configuration, the space for storage, and the installation of the information processing apparatus, such as, the server, etc., for example, the lack-mount method comes to be the main current, and the sizes of the housing thereof are determined in accordance with the standard, i.e., to be installed into the cabinet. With the size of height, being regulated by a multiple of the 1U (1EIA)=44.45mm, as a standard height, there are various kinds of sizes of the housings, from 1U height at the minimum, up to 5U at the maximum, for example, therefore it is desired to build up the liquid cooling device, from which a much higher cooling capacity can be taken out, depending upon sizes of the housings, when the liquid cooling device is applied into those apparatuses.

### BRIEF SUMMARY OF THE INVENTION

An object is, according to the present invention, therefore to provide a liquid cooling device, being installable with high density into the housing of the electronic apparatuses having various sizes thereof, as well as, achieving a low cost of the liquid cooling device.

For accomplishing such the object mentioned above, according to the present invention, first there is provided a liquid cooling device, for an electronic apparatus, comprising: a pump for circulating a cooling liquid; a liquid-cooling jacket for absorbing heat generated from a heat-generation portion into the cooling liquid; and a radiator for radiating the heat stored in the cooling liquid into an outside air, wherein: said radiator is built up with a plural number of radiator cores juxtaposing with, each having a plural number of flat-like tubes, in which said cooling liquid passes through, and being made up with fins provided and fixed between the plural number of tubes, to be an independent radiator core, and each radiator cores is connected to a header at both end portions thereof, so that the cooling liquid flows from said header to said tube.

Also, for accomplishing the object mentioned above, according to the present invention, there is provided a liquid cooling device, for an electronic apparatus, comprising: a pump for circulating a cooling liquid; a liquid-cooling jacket for absorbing heat generated from a heat-generation portion into the cooling liquid; and a radiator for radiating the heat stored in the cooling liquid into an outside air, wherein: said radiator is built up into an independent body, being equal or less than 44mm and equal or greater 35mm in height thereof, which can be assembled with unitary radiators in plural number thereof, each having inlet side connectors at least of two (2) pieces or more and outlet side connectors at least of two (2) pieces or more, in vertical direction and horizontal direction, and being built up by assembling them in either one of the vertical direction or the horizontal direction.

And, further for accomplishing the object mentioned above, according to the present invention, first there is provided a liquid cooling device, for an electronic apparatus, comprising: a pump for circulating a cooling liquid; a liquid-cooling jacket for absorbing heat generated from a heat-generation portion into the cooling liquid; and a radiator for radiating the heat stored in the cooling liquid into an outside air, wherein: said radiator is built up with a plural number of independent single radiator cores, each having a plural number of flat-like tubes, in which said cooling liquid passes through, and being made up with fins provided and fixed between the plural number of tubes, and each radiator cores is connected to a header at both end portions thereof , so that the cooling liquid flows from said header to said tube, thereby building up a unitary radiator, being equal or less than 44mm and equal or greater 35mm in height thereof, to be assembled with said unitary radiators in plural number thereof in vertical direction and horizontal direction, and each having inlet side connectors at least of two (2) pieces or more and outlet side connectors at least of two (2) pieces or more, and being built up by assembling them in either one of the vertical direction or the horizontal direction.

In addition thereto, also for accomplishing the object mentioned above, according to the present invention, there is provided an electronic apparatus, storing a liquid cooling device within a cabinet, said liquid cooling device, comprising: a pump for circulating a cooling liquid; a liquid-cooling jacket for absorbing heat generated from a heat-generation portion into the cooling liquid; and a radiator for radiating the heat stored in the cooling liquid into an outside air, wherein: said radiator building up said liquid cooling device is built up into an independent body, being equal or less than 44mm and equal or greater 35mm in height thereof, to be assembled with unitary radiators in plural number thereof in vertical direction and horizontal direction, each having inlet side connectors at least of two (2) pieces or more and outlet side connectors at least of two (2) pieces or more, and being built up by assembling them in either one of the vertical direction or the horizontal direction.

And, also for accomplishing the object mentioned above, according to the present invention, there is provided an electronic apparatus, storing a liquid cooling device within a cabinet, said liquid cooling device, comprising: a pump for circulating a cooling liquid; a liquid-cooling jacket for absorbing heat generated from a heat-generation portion into the cooling liquid; and a radiator for radiating the heat stored in the cooling liquid into an outside air, wherein: said radiator building up said liquid cooling device is built up with a plural number of independent single radiator cores, each having a plural number of flat-like tubes, in which said cooling liquid passes through, and being made up with fins provided and fixed between the plural number of tubes, and each radiator cores is connected to a header at both end portions thereof, so that the cooling liquid flows from said header to said tube, thereby building up a unitary radiator, and being equal or less than 44mm and equal or greater 35mm in height thereof , to be assembled with said unitary radiators in plural number thereof in vertical direction and horizontal direction, each having inlet side connectors at least of two (2) pieces or more and outlet side connectors at least of two (2) pieces or more, and being build up by assembling them in either one of the vertical direction or the horizontal direction.

In the description mentioned in the above, the horizontal direction means an either one of a direction of ventilation direction, or a direction orthogonal thereto.

### BRIEF DESCRIPTION OF THE SEVERAL VIEWS OF THE DRAWING

Those and other objects, features and advantages of the present invention will become more readily apparent from the following detailed description when taken in conjunction with the accompanying drawings wherein:
Fig. 1 is an outlook view of a 2CPU liquid cooling system, for use in a housing having the 3U height, according to a first embodiment of the present invention;
Fig. 2 is a block diagram of the 2CPU liquid cooling system for use in the housing having the 3U height, according to the first embodiment of the present invention;
Fig. 3 is an outlook view of a server of the lack-mount method, into which the liquid cooling system according to the first embodiment is applied;
Fig. 4 is an outlook view of a 2CPU liquid cooling system for use in a housing having the 3U height, according to a second embodiment of the present invention;
Fig. 5 is a view for showing an example of the structure of a radiator, according to the present invention;
Fig. 6 is a view for showing an example of the structure of the radiator, according to the present invention, in particular, in a case when being combined with in a plural number thereof;
Fig. 7 is a view for showing other example of the structure of the radiator, according to the present invention, in a case when being combined with in a plural number thereof;
Fig. 8 is a view for showing other example of the structure of a radiator, according to the present invention;
Fig. 9 is a view for showing the details of the part, which is shown in Fig. 8 above;
Fig. 10 is a view for showing further other example of the structure of a radiator, according to the present invention; and
Fig. 11 is a view for showing an example of installation of the server of the lack-mount method, but according to the conventional art.

### DETAILED DESCRIPTION OF THE INVENTION

The liquid cooling device according to the present invention is applied into an electronic apparatus, comprising a pump for circulating a cooling liquid, a liquid cooling jacket for absorbing the heat generated from a heat-generation portion into the cooling liquid, and a radiator for radiating the heat condensed within the cooing liquid into an outside air.

The radiator mentioned above has a plural number of flat-like conduits, in each of which the cooling liquid passes through, and fins are disposed (provided) and fixed onto the plural number of conduits, thereby building up a one (1) piece of an independent radiator core. And, both end portions of the radiator core are connected to a header, respectively, so as to enable the cooling liquid to flow from the header into the conduit, thereby building up a unitary radiator.

And, the unitary radiator, beingbuiltup into the independent body; e.g., being equal to or less than 44mm and being equal to or greater than 35mm in the height thereof, and preferably, being equal to or less than 40mm, but within 36mm, and in each of thereof being provided with two (2) pieces of inlet side connectors or more and two (2) pieces of outlet side connectors or more on a header thereof, can be assembled in a plural number thereof in the vertical direction and in the horizontal direction, and the radiator is built up, by assembling them in either one of the vertical direction or the horizontal direction.

### [Example 1]

Hereinafter, explanation will be given on the details of the embodiment 1, according to the present invention, by referring to the drawings attached.

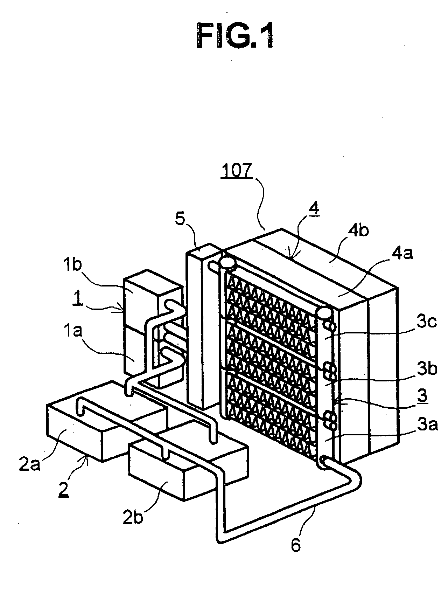

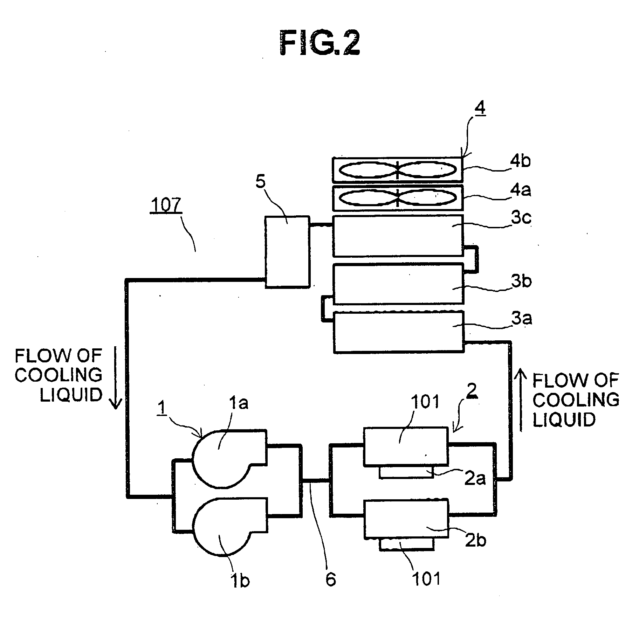

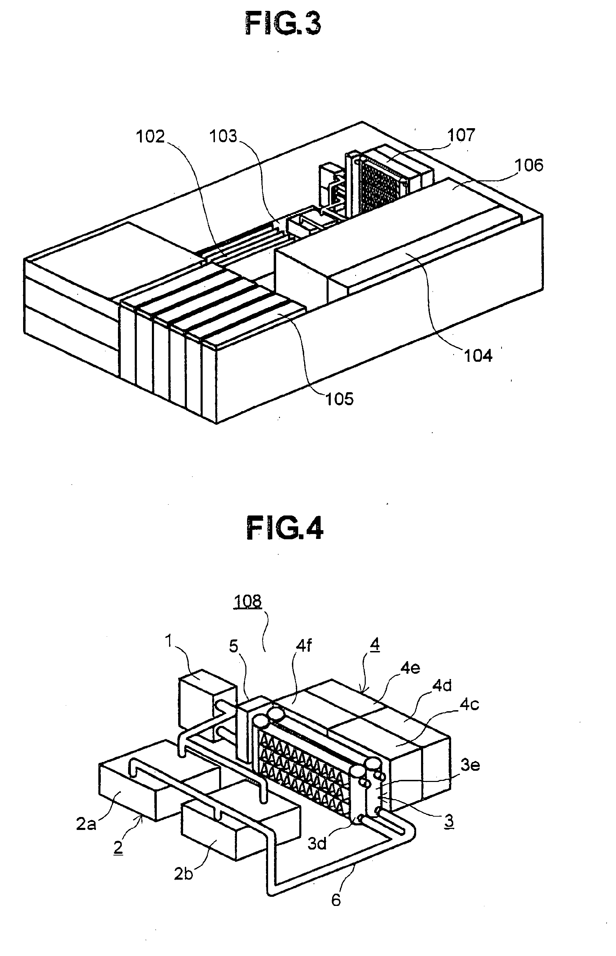

First, as the first embodiment of the present invention, there is shown a liquid cooling device, to be installed into a server of the 2CPU structure having a housing height of 3U (about 133mm). Fig. 1 is a view for showing an outlook of the present liquid cooling device 107. Fig. 2 is a block diagram of the present liquid cooling device. Fig. 3 is a view for showing an outlook of a lack housing of the server of the lack-mount thereof, into which the present liquid cooling device 107 is installed.

The present liquid cooling device is built up with two (2) sets of pumps 1 (1a and 1b), liquid cooling jackets 2 (2a and 2b) for absorbing the heat generated from CPUs into the cooling liquid, each being provided for one CPU, i.e., two (2) pieces in total thereof, three (3) pieces of radiators 3 (3a, 3b, and 3c) for radiating the cooling liquid, two (2) pieces of cooling fans 4 (4a and 4b) for blowing a cooling air upon the radiator for cooling down thereof, and a reservoir 5 having a function of separating a gas component mixing into the cooling liquid. According to the present embodiment, building up the pumps 1 and the fans 4, each in a plural number thereof, accomplishes a redundant system; i.e., protecting the cooling device from falling into the condition that completely no function can be performed, even in a case where one of the pumps 1 or the fans 4 is in trouble, for example.

Among those devices; such as, the pump 1, the liquid-cooling jacket 2, the radiator 3, and the reservoir 5, through which the cooling liquid passes through, each of them is connected through liquid conduits 6, thereby forming a closed loop. In the present embodiment, the pump 1 and the liquid cooling jacket 2 are combined with, to be in parallel with the closed loop. Also, the radiator 3 is combined with, in series to the closed loop.

As the cooling liquid is used a water solution, including mainly propylene glycol therein, for example, therefore the freezing point thereof is at least lower that the freezing pint of water, and further it may contain an anti-corrosive agent therein, such as, for copper or aluminum, for example.

The liquid cooling jacket 2 and the radiator 3, through which the cooling liquid circulates around, are made of a material, being high in the heat conductivity, such as, copper or aluminum, for example. The liquid conduits are made of a metal material in liquid transporting portion thereof, and is combined with a tube made of a organic material group, such as, butyl rubber, for example, in a connecting portion between each of the devices, thereby building up a closed loop of the cooling liquid.

However, on the way of the closed loop, there may be provided a universal joint, etc., attaching to a check valve, thereby making each device being exchangeable or extensible in the structure. With this, exchange of the CPU can be conducted, easily, due to the field extension of the CPU and/or occurrence of trouble therein.

While being circulated bymeans the pump 1, the cooling liquid absorbs the heat generation of the CPU 101 through the liquid cooling jacket 2, and it is cooled down through the cooling air blown by the cooling fan 4 in the radiator 3. The cooling liquid cooled down is then divided into the gaseous component and the liquid in the reservoir 5, and it turns back to the pump 1. In this manner, delivery and receipt of the heat is conducted during the processes of the circulation of cooling liquid, and the heat-generation of the CPU is radiated into an outside air, thereby cooling down the CPU.

From the connecting portion with each of devices, an air invades comes into through a boundary surface of contact and/or the tube made of the organic material group, and it brings about a possibility that it lowers down the liquid transporting capability of the pump 1 and/or decreases the heat-exchanging capacities of the liquid cooling jacket 2 and the radiator 3. For this reason, the reservoir 5 has a gas/liquid separating mechanism for trapping the air therein, so that the air penetrating into does not circulate or stay within the closed loop, and also a function of storing the liquid therein, for compensating a loss of the cooling liquid, which is caused by replacement of the liquid penetrating into an outside of the loop with an air penetrating therein, as a result thereof.

As is shown in Fig. 3, the present cooling device 107 is installed into the server with high density thereof, which has a housing of the 3U height, for example.

Next, explanation will be made on the liquid cooling device 107 according to the present embodiment. The cooling capacity of the liquid cooling is determined, mainly, by the capacity of heat absorption of the liquid-cooling jacket 2, the flow rate of the cooling liquid, the heat radiation capacity of the radiator, and/or an amount of cooling air, but in particular, the structure and the performance of the radiator are important.

Forthepurposeofobtaininganimprovementontheperformance or capacity of the radiator 3, it is desirable that the cross-section area for ventilation is kept to be as large as possible. On the other hand, the server of lack-mount method sucks the air from a front surface of the housing, and the cooling air is discharged from the rear surface of the housing in the periphery thereof, as was explained by referring to Fig. 11 in the above, therefore for the purpose of maintaining the cross-section area for ventilation to be wide, it is desirable to alter the height of the radiator fitting to the height of the housing.

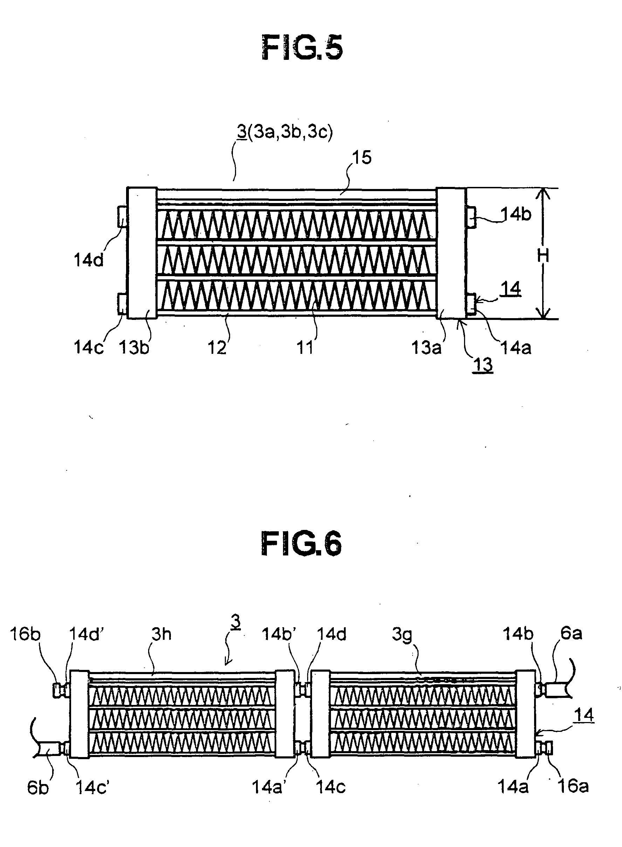

In the present embodiment, the height of the lack H of the radiator 3, i.e., the height of a main body of the radiator 3 is within 44mm and equal or greater than 35mm, and in particular, it is determined to be 38mm and equal to 36mm or greater than that (regarding the H, see Fig. 5). Namely, this is the height corresponding to the 1U height, and it builds up the structure, for the server of the height of 1U, being the minimum height of the server of lack-mount method, for example, to be installed with high density, so that, in more details, the cross-section area for ventilation can be maintained to be wide much more. In the first embodiment, for installing the radiator into the server of 3U height with high density thereof, the unitary radiators 3a, 3b and 3c are piled up into three (3) stages. In the similar manner to this embodiment, for the housing of the 2U height or the 4U height, the installing can be made easily, by piling up into two (2) stages or four (4) stages, respectively, with maintaining the cross-section area for ventilation to be wide, respectively, but without changing the independent construction of the unitary radiators 3a, 3b and 3c; i.e., without increasing the sorts or kinds of the unitary radiators.

### [Embodiment 2]

Next, as a second embodiment of the present invention, an outlook of the liquid cooling device, to be installed into the server of the 2CPU structure having the 1U (about 44mm) height of the housing. The same reference numerals are attached with, for the structures same or similar to those shown in the embodiment 1, therefore the explanation thereon will not be repeated herein. It is also true to other embodiments. This Fig. 4 is a view for showing an outlook of the present liquid cooling device 108, and it is constructed with assumption that it is installed into the server having the 1U height as shown in Fig. 11 mentioned above, for example. The heights of the pump 1, the liquid cooling jacket 2, the unitary radiator 3d, 3e, and the reservoir 5 are set to be within the 1U height. As is shown in the figure, the unitary radiators 3d and 3e are disposed in the horizontal direction, juxtaposing with. In this case, the horizontal direction means the forward direction with respect to the direction of ventilation.

In the second embodiment, for enabling the installation into the housing of the 1U height, the unitary radiators 3d and 3e are disposed in series to the ventilation passage. With this structure, the temperature goes up of an air coming into the radiator that is located in a downstream side with respect to the unitary radiator 3e located in an upper stream side of the cooling air, therefore it is preferable to install them in such manner that the ventilation passage is in parallel with, as indicated in Fig. 6, which will be mentioned above, in particular, in a case where further improvement is needed on the cooling performance or capacity thereof.

Next, explanation will be given about the structure of the radiator, which is applied into those embodiments.

Fig. 5 shows an example of the structure of the radiator 3. The radiator 3 is built up, as was mentioned in the above, by combining the unitary radiators of the independent structure. A corrugated fin 11 for conducting heat exchange between the cooling air and the flat tubes 12, in which the cooling liquid passes through, are piled up in a plural number of stages, and those are thermally connected with one another, thereby building up the radiator core 17, to which headers 13 for use of distributing/collecting the cooling liquid are combined with. Onto the headers are attached connectors 14 (i.e., connectors 14a and 14b at an inlet side opening side, and connectors 14c and 14d at the outlet opening side thereof), to be connected with the liquid distribution conduits. For those connectors, as shown in the figure, it is preferable that one (1) thereof is connected to one (1) of the headers 13a and 13b, vertically; i.e., two (2) pieces thereof in total, and with such the structure thereof, a degree of freedom of the conduits can increased up, in particular, when the unitary radiator are combined with in a plural number thereof, and at the same time, it enables the wiring of conduits for preventing the gas from being trapped within the radiator 3.

Also, in the liquid cooling device, there is a necessity of a reservoir for trapping the gas therein, which penetrates into the closed loop, therefore, as shown in Fig. 5, for example, it is desirable to provide the reservoir 15 within an inside of the radiator 3, to be combined with in one body, thereby reducing the number of the parts.

### [Example 3]

Fig. 6 shows an example of the structure, in a case where two (2) sets of the unitary radiators shown in Fig. 5 mentioned above, being combined with each other, are installed, aligning in series in a direction on a plan, and it is the structure being applicable into the liquid cooling system for use in the server of the 1U height, shown as the second embodiment in the above, for example. In this example, the unitary radiators are combined with in the horizontal direction, and in this case, the horizontal direction means the direction, being orthogonal (90°) to the ventilation direction. In this combination, sealing caps 16 (16a and 16b) are out on the connectors, on which the connection is unnecessary, and the liquid conduits 6 are connected only to the necessary connectors 14b and 14c'. Thus, the connectors 14d, 14b': 14c, 14a between the unitary radiators 3e and 3f are connected with, respectively.

### [Example 4]

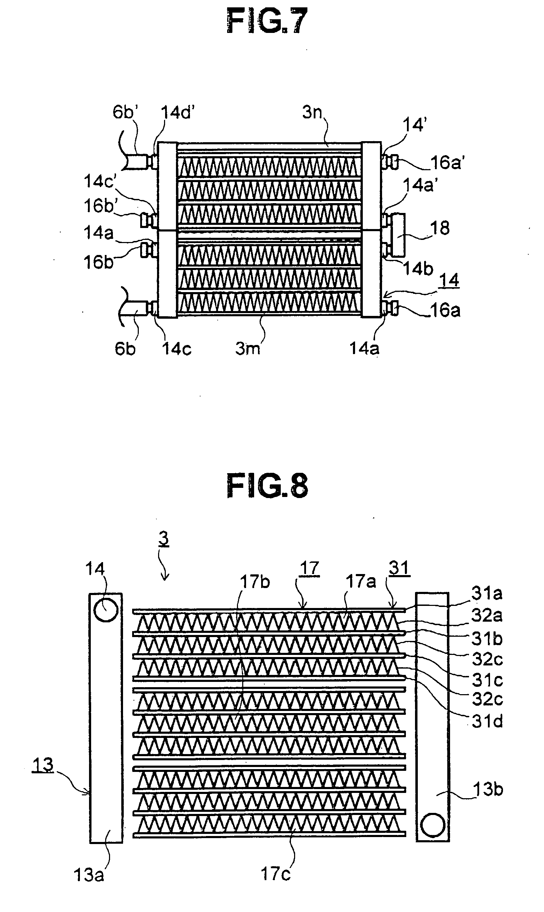

Fig. 7 shows an example of the structure, in a case where the two (2) sets of the unitary radiators 3m and 3n, shown in Fig. 5 mentioned above, being combined with each other, are installed as a radiator, being piled up in two (2) stages, wherein it is assumed that it is applied into the server of the 2U height. Between the connectors 14b and 14a' is provided a connect conduit 18.

### [Example 5]

Fig. 8 shows a method for building up the radiator 3 mentioned above. In the figure, the radiator 3 is build up with three (3) pieces of independent radiator cores 17 (17a, 17b, 17c) and headers 13 (13a, 13b), which are connected to both end portions of those radiator cores 17. Each of the radiator cores 17 is made up with flat-shaped conduits 31 (31a, 31b, 31c, 31d) and fins 32 (32a, 32b, 32c) that are provided therebetween, however it is important that the flat-shaped conduits and the fins 32 are formed to be unified into a one independent body. With doing this, the radiator 3 can be manufactured, cheaply, through multiplying the radiator cores of the same shape. However, it is of course that the cooling liquid passes through within the flat-shaped conduit 31.

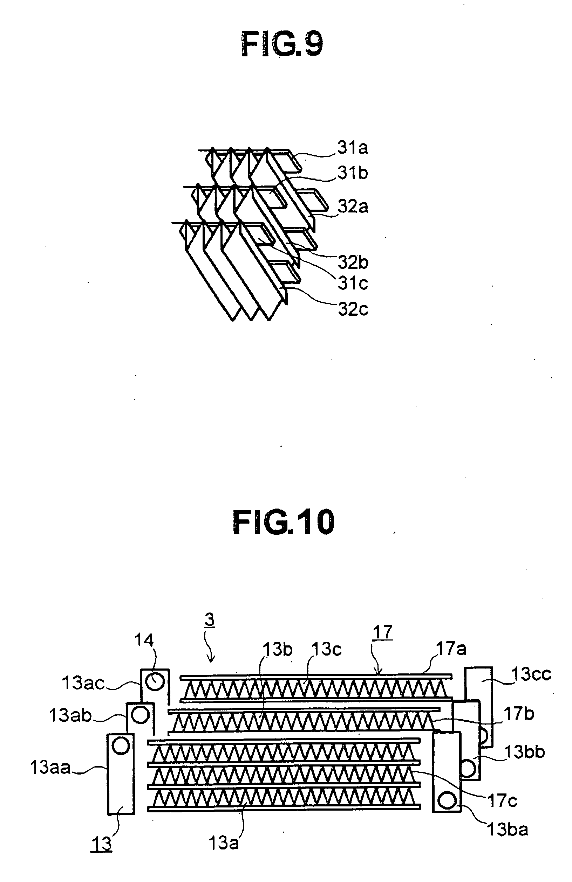

Fig. 9 shows a principle portion of the radiator core 17. As shown in the figure, the radiator core 17 is made up with the flat-shaped conduits (i.e., flat tubes) 31a, 31b and 31c (31d is not shown in the figure) and the fins 32a, 32b and 32c, and the fins 32a, 32b and 32c are disposed (provide) and fixed between those flat-shaped conduits 31a, 31b and 31c, respectively, thereby building up an independent body.

In Fig. 8 mentioned above, the radiator cores 17a, 17b and 17c are also made up, through the same method.

Also, the radiators 3 in Figs. 1 to 7 mentioned above are also made up, through the same method.

Fig. 10 shows a variation of the example shown in Fig. 8 mentioned above, wherein the parts being same to those shown in Fig. 8 are attached with the same reference numerals, and therefore explanation thereof is omitted herein. In the example shown in Fig. 10, the radiator cores 17a, 17b and 17c are respectively attached to the header 13aa, 13ba; 13ab, 13bb; 13ac, 13cc, separately. Accordingly, each of the unitary radiators is made up with one radiator core 17a and the headers 13aa and 13ba, thereby building up the radiator 3, in the manner as shown in Figs. 1 to 7 mentioned above.

With those structures, the radiator is build up in the structure, in which a plural number of the radiator cores are disposed juxtaposing with, each having the flat-shaped conduits in a plural number thereof, in which the cooling liquid passes through, and the fins are provided and connected between the plural number of conduits, thereby building up an independent radiator, while both end portions of each radiator core are connected to the headers, respectively, so that the cooling liquid flows from the headers to the conduits.

Furthermore, the radiator is built up in the structure, in which an independent radiator core is built up with a plural number of the flat-shaped conduits, in which the cooling liquid passes through, and the fins disposed and fixed between the plural number of the conduits, and both end portions of the radiator core are connected to the headers, respectively, thereby building up a unitary radiator, so that the cooling liquid flows from the headers to the conduits, being an independent body equal or less than 44mm and equal or greater 35mm in height thereof, and a plural number of the unitary radiators, each having at least of two (2) pieces or more of inlet opening side connectors and at least of two (2) pieces or more of outlet opening side connectors therewith, can be assembled in the vertical direction and the horizontal direction, and the radiator is build up, by combining them into either one of the vertical direction or the horizontal direction.

In Figs. 8 to 10 are shown the method for building up the radiator 3. In Fig. 8, the radiator 3 is build up by piling up a plural number of the radiator cores 17, each of which is made up with the fin 32 for conducting the heat exchange between the cooling air and the radiator core 17 and the flat-shaped conduits 31, in which the cooling liquid flows through, thereby making up this radiator core 3 to be a common component, being applicable into the servers having various housing heights. With the example shown in Fig. 10, the radiator cores 17 made up of the 1U height are aligned in three (3) pieces thereof, thereby building up the radiator 3, therefore it is possible to maintain the ventilation cross-section area wide, fitting to the housing height, while making such the part component being applicable in common.

With the embodiments shown herein, the explanation was given that the parts to be cooled down are the CPUs 101, however it is possible to cool others than that, i.e., the memories 102 or chip-sets, or the storage devices 105, such as, HDD, etc., by using such the liquid cooling system. In this case, it is preferable to connect the liquid-cooling jackets to the parts in need of cooling thereof, thermally, while connecting themto the circulation route of the cooling liquid, in series or in parallel with the cooling of the CPUs.

As was fully explained in the above, according to the present invention, it is possible to build up the liquid cooling device, being able to maintain a wide ventilation cross-section area depending upon the respective housing height, by combining a plural number of unitary radiators, as a main device of the liquid cooling apparatus, each being of the structure of only one (1) kind of an independent structure. For this reason, it is possible to achieve the radiator of a low cost through mass production of the only one kind of radiator, without losing the high cooling capacity of the liquid cooling derive.

The present inventionmaybe embodied in other specific forms without departing from the spirit or essential feature or characteristics thereof. The present embodiment(s) is/are therefore to be considered in all respects as illustrative and not restrictive, the scope of the invention being indicated by the appended claims rather than by the forgoing description and range of equivalency of the claims are therefore to be embraces therein.

## Claims

1. A liquid cooling device (107), for an electronic apparatus, comprising:
a pump (1) for circulating a cooling liquid;
a liquid-cooling jacket (2) for absorbing heat generated from a heat-generation portion into the cooling liquid; and
a radiator (3) for radiating the heat stored in the cooling liquid into an outside air, wherein:
said radiator (3) is built up with a plural number of radiator cores (3a, 3b, 3c) juxtaposing with, each having a plural number of flat tubes (12), in which said cooling liquid passes through, and being made up with fins (11) provided and fixed between the plural number of tubes (12), to be an independent radiator core (17), and each radiator cores (17) is connected to a header ( 13) at both end portions thereof, so that the cooling liquid flows from said header (13) to said tube (12).

2. A liquid cooling device (108), for an electronic apparatus, comprising:
a pump (1) for circulating a cooling liquid;
a liquid-cooling jacket (2) for absorbing heat generated from a heat-generation portion into the cooling liquid; and
a radiator (3) for radiating the heat stored in the cooling liquid into an outside air, wherein:
said radiator (3) is built up into an independent body, being equal or less than 44 mm and equal or greater 35 mm in height thereof, which can be assembled with unitary radiators (3d, 3e) in plural number thereof, each having inlet side connectors (14a, 14b) at least of two (2) pieces or more and outlet side connectors (14c, 14d) at least of two (2) pieces or more, in vertical direction and horizontal direction, and being built up by assembling them in either one of the vertical direction or the horizontal direction.

3. A liquid cooling device as is described in claim 2, wherein:
said radiator (3) is built up with a plural number of independent single radiator cores (17a, 17b, 17c), each having a plural number of flat tubes (12), in which said cooling liquid passes through, and being made up with fins (11) provided and fixed between the plural number of tubes (12), and each radiator cores (17a, 17b, 17c) is connected to a header (13a, 13b) at both end portions thereof, so that the cooling liquid flows from said header (13a, 13b) to said tube, thereby building up a unitary radiator (3).

4. The liquid cooling device, as is described in the claim 2 or 3, wherein said horizontal direction indicates either one of a ventilation direction and an orthogonal direction to that.

5. An electronic apparatus, storing a liquid cooling device according to claim 2 or 3 within a cabinet.
